(19) Europäisches Patentamt / European Patent Office / Office européen des brevets

(11) **EP 2 392 148 B1**

(12) **EUROPÄISCHE PATENTSCHRIFT**

(45) Veröffentlichungstag und Bekanntmachung des Hinweises auf die Patenterteilung:
**17.07.2013 Patentblatt 2013/29**

(21) Anmeldenummer: **10700865.8**

(22) Anmeldetag: **15.01.2010**

(51) Int Cl.:
***G01R 29/12*** *(2006.01)*

(86) Internationale Anmeldenummer:
**PCT/EP2010/050468**

(87) Internationale Veröffentlichungsnummer:
**WO 2010/086240 (05.08.2010 Gazette 2010/31)**

(54) **MIKROFONBAUELEMENT UND VERFAHREN ZUM BETREIBEN EINES SOLCHEN**

MICROPHONE COMPONENT AND METHOD FOR OPERATING A COMPONENT OF THIS TYPE

COMPOSANT DE MICROPHONE ET PROCÉDÉ POUR FAIRE FONCTIONNER UN COMPOSANT DE CE TYPE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **02.02.2009 DE 102009000535**
**18.02.2009 DE 102009000950**

(43) Veröffentlichungstag der Anmeldung:
**07.12.2011 Patentblatt 2011/49**

(73) Patentinhaber: **Robert Bosch GmbH**
**70442 Stuttgart (DE)**

(72) Erfinder:
• **BUCK, Thomas**
**71732 Tamm (DE)**
• **LAERMER, Franz**
**71263 Weil Der Stadt (DE)**

(56) Entgegenhaltungen:
**WO-A1-2005/076466    US-A1- 2006 008 097**

**Beschreibung**

Stand der Technik

Die Erfindung betrifft ein Mikrofonbauelement mit einem mikromechanisch realisierten Mikrofonkondensator, mit einem akustisch nicht aktiven Kompensationskondensator, mit Mitteln zum Anlegen eines hochfrequenten Abtastsignals an den Mikrofonkondensator und zum Anlegen des invertierten Abtastsignals an den Kompensationskondensator, mit einem integrierenden Operationsverstärker, der die Summe des Stromflusses durch den Mikrofonkondensator und des Stromflusses durch den Kompensationskondensator als Ladungsverstärker aufintegriert, mit einem mit dem Abtastsignal synchronisierten Demodulator für das Ausgangssignal des integrierenden Operationsverstärkers und mit einem Tiefpassfilter, um aus dem Ausgangssignal des Demodulators ein den Kapazitätsänderungen des Mikrofonkondensators entsprechendes Mikrofonausgangssignal zu gewinnen.

Des Weiteren betrifft die Erfindung Verfahren zum Betreiben eines solchen Mikrofonbauelements.

Kapazitive MEMS(Micro-Electro-Mechanical-System)-Mikrofone, wie in der US 2006/008097, gewinnen in den unterschiedlichsten Anwendungsbereichen zunehmend an Bedeutung. Dies ist im Wesentlichen auf die miniaturisierte Bauform derartiger Bauelemente und die Möglichkeit zur Integration weiterer Funktionalitäten bei sehr geringen Herstellungskosten zurückzuführen. Besonders vorteilhaft ist die Integration von Signalverarbeitungskomponenten, wie Filtern und Komponenten zur Rauschunterdrückung sowie Komponenten zum Erzeugen eines digitalen Mikrofonsignals. Ein weiterer Vorteil von MEMS-Mikrofonen ist deren hohe Temperaturstabilität, was z.B. deren Aufbau in sogenannten "Reflow-Lötprozessen" gestattet.

Der Mikrofonkondensator besteht in der Regel aus einer Membran, die durch den Schalldruck ausgelenkt wird und als bewegliche Elektrode fungiert, sowie einer akustisch inaktiven feststehenden Gegenelektrode. Durch den Schalldruck verändert sich der Abstand zwischen der Membran und der Gegenelektrode und damit auch die Kapazität des Mikrofonkondensators. Diese sehr kleinen Kapazitätsänderungen in der Größenordnung von aF müssen in ein verwertbares elektrisches Signal umgewandelt werden.

Ein in der Praxis häufig umgesetztes Konzept beruht darauf, den Mikrofonkondensator über einen hochohmigen Ladewiderstand mit einer Gleichspannung aufzuladen. Kapazitätsänderungen des Mikrofonkondensators werden dann als Schwankungen der Ausgangsspannung erfasst, die über einen Impedanzkonverter verstärkt wird. Dabei kann es sich beispielsweise um einen JFET handeln, der den hohen Widerstand des Mikrofons in der Größenordnung von GOhm in einen relativ niedrigen Ausgangswiderstand in der Größenordnung von einigen 100 Ohm umwandelt, ohne die Ausgangsspannung selbst zu verändern. Anstelle eines JFET kann auch eine Operationsverstärkerschaltung verwendet werden, die einen niedrigen Ausgangswiderstand liefert. Im Unterschied zum JFET kann hier der Verstärkungsfaktor an die jeweiligen Mikrofonerfordernisse angepasst werden. Dieses Konzept erweist sich in mehrerlei Hinsicht als problematisch:

So lassen sich die digitalen Schaltungselemente nicht ohne Weiteres zusammen mit den analogen Signalverarbeitungskomponenten in CMOS-Technologie realisieren, da dabei Elektrorauschen, sogenanntes 1/f-Rauschen, auftritt. Die erforderliche rauscharme JFET-Technologie kann im Rahmen von Standard CMOS-Prozessen nicht realisiert werden, sondern erfordert relativ teure Spezialprozesse.

Aufgrund der am Mikrofonkondensator anliegenden Gleichspannung herrschen während des Mikrofonbetriebs elektrostatische Anziehungskräfte zwischen der Membran und der Gegenelektrode. Diese sind insbesondere in Überlastsituationen kritisch, da sie ein dauerhaftes Anhaften der Membran an der Gegenelektrode begünstigen, was zu einem Zusammenbruch der Mikrofonfunktion führt. Zum Lösen der Membran von der Gegenelektrode muss der Mikrofonkondensator in der Regel vollständig entladen werden. In der Praxis versucht man mit mechanischen Maßnahmen, wie z.B. einer relativ steifen Membranaufhängung, einem relativ großen Abstand zwischen Membran und Gegenelektrode oder mechanischen Anschlägen, einen derartigen elektrostatischen Kollaps zu vermeiden. Diese Maßnahmen wirken sich jedoch meist nachteilig auf die Empfindlichkeit des Mikrofons aus oder sind herstellungstechnisch sehr aufwendig.

Schließlich sei noch erwähnt, dass eine relativ hohe Gleichspannung in der Größenordnung von 10 Volt und mehr an den Mikrofonkondensator angelegt werden muss, um einen hinreichend hohen SNR(signal-to-noise-ratio) zu erzielen. Eine Ladespannung dieser Größenordnung erfordert aber häufig einen vergleichsweise großen Abstand zwischen der Membran und der Gegenelektrode in der Größenordnung von >>2μm oder eine sehr steife Membrankonstruktion, um einerseits einen elektrostatischen Kollaps zu vermeiden und andererseits einen hinreichend großen Auslenkungsbereich für die Membran zur Verfügung zu stellen. Derartig große Abstände oder sehr steife Membrankonstruktionen lassen sich nicht ohne Weiteres mit Standardverfahren der Oberflächenmikromechanik herstellen. Außerdem kommt es bei derart hohen Ladespannungen in Überlastsituationen mit Berühren von Membran und Gegenelektrode nicht nur zu einem Anhaften der Membran an der Gegenelektrode sondern zu einem irreversiblen Verschmelzen der Kontaktoberflächen durch Stromfluss. In der Praxis versucht man, dies mit Hilfe von Isolationsschichten zu verhindern. Diese erhöhen jedoch die Komplexität des Herstellungsverfahrens und damit letztlich die Kosten für ein derartiges Mikrofonbauelement.

Mit der deutschen Patentanmeldung 10 2009 000950.7 A1 wird ein Mikrofonbauelement der eingangs genannten Art vorgeschlagen, das auf einem relativ niedrigen Spannungsniveau betrieben werden kann und dennoch eine vergleichsweise hohe Empfindlichkeit und SNR aufweist.

Das diesem MEMS-Mikrofon zugrundeliegende Konzept sieht vor, ein hochfrequentes Abtastsignal an den Mikrofonkondensator anzulegen und das invertierte Abtastsignal an einen einstellbaren aber akustisch nicht aktiven Kompensationskondensator anzulegen. Mit Hilfe eines integrierenden Operationsverstärkers wird die Summe des Stromflusses durch den Mikrofonkondensator und des Stromflusses durch den Kompensationskondensator aufintegriert. Das Ausgangssignal des integrierenden Operationsverstärkers wird dann mit Hilfe eines mit dem Abtastsignal synchronisierten Demodulators demoduliert. Durch eine Tiefpassfilterung des demodulierten Signals wird schließlich ein den Kapazitätsänderungen des Mikrofonkondensators entsprechendes Mikrofonsignal gewonnen.

Im Falle der DE 10 2009 000950.7 A1 handelt es sich bei dem hochfrequenten Abtastsignal um ein symmetrisches Taktsignal in Form einer Rechteckspannung mit einem 1:1-Verhältnis der Taktzeiten.

Der einstellbare Kompensationskondensator dient der Kompensation des Stromflusses, der durch den Mikrofonkondensator fließt und nicht auf Schalleinwirkungen zurückzuführen ist. Damit soll erreicht werden, dass der Eingang des darauffolgenden Ladungsverstärkers in der Nähe seiner Nullpunktspannung betrieben wird. Idealerweise wird der Kompensationskondensator entsprechend der Ruhekapazität des Mikrofonkondensators eingestellt. Da am Kompensationskondensator das invertierte Taktsignal anliegt, während der Mikrofonkondensator mit dem Taktsignal gespeist wird, integriert der Operationsverstärker nur den Anteil des Stromflusses durch den Mikrofonkondensator auf, der auf die schallbedingten Kapazitätsänderungen des Mikrofonkondensators und damit auf Symmetrieabweichungen zurückzuführen ist. Aus dem Ausgangssignal des integrierenden Operationsverstärkers lässt sich dann relativ einfach ein diese Kapazitätsänderungen wiedergebendes Mikrofonsignal gewinnen, nämlich durch synchronisierte Demodulation und Tiefpassfilterung.

Diese Art der Signalerfassung liefert bereits bei einem Spannungsniveau des hochfrequenten Taktsignals von unter 2 Volt eine akzeptable Empfindlichkeit bzw. einen hinreichend hohen SNR. Dies ist insbesondere auch in Überlastsituationen von Vorteil. Bei Spannungen dieser Größenordnung führt nämlich eine Berührung zwischen der Membran und der Gegenelektrode nicht zum Verschmelzen der Kontaktoberflächen und damit auch nicht zur Zerstörung der Mikrofonstruktur. Deshalb kann hier auf einen mechanischen Überlastschutz in Form von elektrisch isolierenden Anschlägen verzichtet werden. Außerdem lassen sich sowohl die mikromechanische Struktur dieses Mikrofonbauelements als auch dessen schaltungstechnische Komponenten zur Signalerfassung einfach mit Standardprozessen der MEMS-Technologie bzw. der CMOS-Technologie und damit sehr kostengünstig erzeugen.

Aufgrund der geringen Baugröße, der relativ hohen Empfindlichkeit und der geringen Herstellungskosten eignet sich das in der DE 10 2009 000950.7 A1 beschriebene Mikrofonbauelement sehr gut für den Einsatz in portablen Geräten, die in großer Stückzahl hergestellt werden, wie z.B. Handys. Für derartige Anwendungen muss der Stromverbrauch des Mikrofonbauelements möglichst gering gehalten werden. Ein dominierender Stromverbraucher des in der DE 10 2009 000950.7 A1 beschriebenen Mikrofonbauelements ist der integrierende Operationsverstärker, der als rauscharmer Ladungsverstärker betrieben wird.

Offenbarung der Erfindung

Mit der vorliegenden Erfindung wird ein Konzept zur Reduzierung des Stromverbrauchs eines Mikrofonbauelements der eingangs genannten Art vorgeschlagen, das sich weder auf die Mikrofonperformance noch auf das Mikrofonverhalten negativ auswirkt.

Das erfindungsgemäße Konzept sieht vor, als hochfrequentes Abtastsignal eine periodische Abfolge von Abtastimpulsen und Pausenzeiten zu verwenden. Während der Pausenzeiten wird der Stromfluss durch den integrierenden Operationsverstärker mit Hilfe eines ersten Schaltelements reduziert und ggf. auch der Stromfluss durch weitere, während der Pausenzeiten nicht benötigte Schaltungskomponenten. Der Tiefpassfilter weist erfindungsgemäß eine "sample-and-hold"-Charakteristik auf, so dass der Tiefpassfilter in den Pausenzeiten jeweils das Ausgangssignal des integrierenden Operationsverstärkers zeitgemittelt über den vorangegangenen Abtastvorgang speichert. Im Falle eines digitalen Ausgangssignals wird einfach ein binärer Bitwert während der Pausenzeiten gespeichert.

Demnach wird der zeitliche Ablauf des Abtastprozesses gegenüber der in der DE 10 2009 000950.7 A1 beschriebenen Betriebsvariante dahingehend modifiziert, dass Pausenzeiten zwischen die eigentlichen Abtastvorgänge eingeschoben werden. Erfindungsgemäß wird dabei ausgenutzt, dass sich das vom Mikrofonbauelement zu erfassende akustische Signal in einem Frequenzbereich unterhalb von ca. 25 kHz bewegt, während die Abtastrate eines hochfrequenten Taktsignals üblicherweise im MHz-Bereich liegt, z.B. > 500 kHz. Solange die Pausenzeiten so gewählt werden, dass die Abtastrate mindestens doppelt so groß ist wie die höchste zu erfassende Schallfrequenz, wirkt sich die erfindungsgemäße Modifizierung des Abtastprozesses also nicht nachteilig auf die Qualität des Mikrofonsignals aus. Erfindungsgemäß ist zudem erkannt worden, dass der integrierende Operationsverstärker nur während der Abtastvorgänge zur Erzeugung des Mikrofonsignals beiträgt, nicht aber in den Pausenzeiten. Folglich kann der Stromfluss durch den Operationsverstärker in den Pausenzeiten deutlich reduziert werden, wenn das Ausgangssignal des Operationsverstärkers gemittelt über jeden Abtastvorgang über die jeweils folgende Pausenzeit gespeichert wird. Dies wird erfindungsgemäß durch eine "sample-and-hold"-Charakteristik des nachgeschalteten Tiefpassfilters gewährleistet. Auch weitere während der Pausenzeiten nicht benötigte Schaltungskomponenten können abgeschaltet werden oder im Stromverbrauch reduziert werden

Da der integrierende Operationsverstärker wesentlich zum Stromverbrauch des hier in Rede stehenden Mikrofonbauelements beiträgt, kann der Gesamtstromverbrauch durch die erfindungsgemäße Modifizierung des Abtastvorgangs sehr effektiv reduziert werden. In einer besonders stromsparenden Betriebsvariante wird der integrierende Operationsverstärker während der Pausenzeiten ganz abgeschaltet, d.h. der Stromverbrauch des Operationsverstärkers wird hier auf Null gesetzt.

In einer Variante des erfindungsgemäßen Mikrofonbauelements umfasst der dem integrierenden Operationsverstärker nachgeschaltete Demodulator mindestens ein zweites Schaltelement, mit dem die elektrische Verbindung zwischen dem integrierenden Operationsverstärker und dem nachgeschalteten Tiefpassfilter während der Pausenzeiten unterbrochen wird.

Grundsätzlich gibt es verschiedene Möglichkeiten für die Realisierung der erfindungsgemäßen Abtastung der Mikrofonkapazität, sowohl was die Dauer der Pausenzeiten als auch was die Abfolge der Abtastimpulse und Pausenzeiten betrifft, solange die Abtastrate effektiv mindestens doppelt so groß ist wie die höchste zu erfassende Schallfrequenz.

In einer vorteilhaften Variante besteht das Abtastsignal aus einer periodischen Abfolge von alternierend positiven und negativen Abtastimpulsen jeweils gefolgt von einer definierten Pausenzeit. Bei dieser Variante wird das aus der DE 10 2009 000950.7 A1 bekannte Abtastsignal also durch Einfügen von definierten Pausenzeiten zwischen den einzelnen Abtastimpulsen modifiziert. Dadurch werden keine neuen Zusatzfrequenzen in den Abtastvorgang eingeführt, so dass Interferenzen oder Nebeneffekte aus mehreren Frequenzen im Abtastprozess bzw. Aliasing-Phänomene höherer Ordnung ausgeschlossen sind.

Bei dieser Variante des Abtastsignals geht die erfindungsgemäße Reduzierung des Stromflusses durch den integrierenden Operationsverstärker während der Pausenzeiten mit einer entsprechenden Reduzierung der Korrelation des 1/f-Rauschsignals zwischen den aufeinanderfolgenden Abtastimpulsen einher. Bei einer Abschaltung des Operationsverstärkers geht diese Korrelation gänzlich verloren. Dies erschwert eine effiziente Unterdrückung des 1/f-Rauschens, das auch als "flicker-noise" bezeichnet wird und im hier relevanten Frequenzbereich deutlich ausgeprägt ist. Demzufolge wird man bei dieser Ausführungsform der Abtastung den Operationsverstärker des Ladungsverstärkers nicht ganz abschalten sondern in den Pausen mit einem minimalen Ruhestrom versorgen, damit die Rauschkorrelation zwischen den einzelnen Abtastvorgängen nicht verloren geht.

Dieser Problematik trägt eine weitere vorteilhafte Variante des Abtastsignals Rechnung, das aus einer periodischen Abfolge von zwei unmittelbar aufeinanderfolgenden Abtastimpulsen gegensätzlicher Polarität und einer definierten Pausenzeit besteht. Bei dieser Variante bleibt die Rauschkorrelation des 1/f-Rauschanteils zwischen den beiden unmittelbar aufeinanderfolgenden Abtastimpulsen erhalten, unabhängig davon wie weit der Stromfluss durch den Operationsverstärker während der Pausenzeiten reduziert wird. Auch wenn die Rauschkorrelation nicht über die Pausenzeiten erhalten bleibt, kann hier der "flicker-noise"-Anteil effektiv unterdrückt werden. Allerdings sind in diesem Fall zwei Frequenzen am Abtastvorgang beteiligt, nämlich zum einen die schnelle Wiederholfrequenz der Abtastimpulse, die beispielsweise in der Größenordnung von 500 kHz und höher liegt, und zum anderen die langsamere Abtastfrequenz, d.h. die Wiederholrate der Abtastsequenzen, die meist im Bereich von 50kHz liegt. Dieser Abtastfrequenz entsprechend muss der Tiefpassfilter am Ausgang mit einer steilen Abfallcharakteristik oberhalb seiner Eckfrequenz ausgelegt werden, um ein Übersprechen der Abtastimpulse selbst bzw. der Abtastvorgänge auf den Ausgang zu unterdrücken. Zudem ist durch eine eingangsseitige Unterdrückung von Mikrofonsignalen oberhalb der halben niedrigsten Abtastfrequenz sicherzustellen, dass keine Aliasing-Phänomene auftreten können.

Bei der vorgenannten Abtastvariante lässt sich die Absenkung des effektiven Stromverbrauchs des integrierenden Operationsverstärkers anhand des "duty cycle"-Werts r bestimmen, wobei r bestimmt ist als Zeitverhältnis:

$$r = (\text{Abtastimpuls1} + \text{Abtastimpuls2}) / (\text{Abtastimpuls1} + \text{Abtastimpuls2} + \text{Pause})$$

Bei einer Abschaltung des integrierenden Operationsverstärkers während der Pausenzeiten reduziert sich der mittlere Stromverbrauch gegenüber der Betriebsvariante ohne Reduzierung des Stromflusses durch den Operationsverstärker um den Faktor r.

Wie bereits angedeutet, nimmt das Rauschen hinter dem Demodulator in Folge dieser Abtastung zu, und zwar um den Faktor $1/\sqrt{r}$. Dieser Anstieg des Rauschpegels N im Signal-Rauschabstand SNR = S/N lässt sich durch eine entsprechende Erhöhung des Mikrofonsignalpegels S kompensieren. Dazu kann beispielsweise einfach die Abtastspannung um den Faktor 1/sqrt(r) erhöht werden. Eine andere Möglichkeit zur Erhöhung des Mikrofonsignalpegels besteht in einer Reduzierung des designten Gapabstands im MEMS-Mikrofon. Der Signalpegel des Mikrofonsignals kann auch durch eine Kombination aus Gapreduzierung und Erhöhung der Abtastspannung angehoben werden. Vorteilhafterweise erhöht sich das Risiko für das Auftreten eines elektrostatischen Kollaps der Mikrofonstruktur nicht, solange diese Maßnahmen lediglich der Kompensation des abtastungsbedingten Rauschens unter den angegebenen Faktoren als Randbedingungen dienen. Die auf die Mikrofonmembran wirkende elektrostatische Kraft skaliert nämlich mit dem Quadrat der angelegten Spannung, also - 1/r, und mit der Zeitdauer, über die diese Spannung effektiv anliegt, also - r. Die Wirkung einer um 1/sqrt(r) erhöhten Spannung, die nur im Zeitverhältnis r anliegt, entspricht also stets der Wirkung eines Taktsignals, wie in der DE 10 2009 000950.7 A1 beschrieben, das für die Funktion des Mikrofonbauelements unproblematisch ist.

In einer besonders vorteilhaften Ausführungsform der Erfindung wird der Kompensationskondensator automatisch an die Ruhekapazität des Mikrofonkondensators angepasst. Dieser Regelung wird z.B. der Gleichspannungsanteil des Demodulator-Ausgangssignals zugrundegelegt, da dieser Gleichspannungsanteil der quasi-statischen Asymmetrie zwischen Mikrofon- und Kompensationskondensator entspricht. Der Gleichspannungsanteil lässt sich sehr einfach mit Hilfe eines dem Demodulator nachgeschalteten Offset-Filters ermitteln. Um sicher zugehen, dass tatsächlich nur der Gleichspannungsanteil herausgefiltert wird, sollte die obere Grenzfrequenz dieses Offset- Filters deutlich unter der unteren Grenzfrequenz des Mikrofons liegen. Der Kompensationskondensator wird nun einfach so eingestellt, dass der Gleichspannungsanteil des Demodulator-Ausgangssignals minimiert wird.

Dazu kann der einstellbare Kompensationskondensator beispielsweise in Form einer schaltbaren Kondensatorbank realisiert sein. Diese kann eine binäre Verteilung von Kapazitätswerten und/oder eine Reihe von gleichen Kapazitätswerten umfassen, die wahlweise zusammengeschaltet werden. Anstelle der Variation des Kompensationskondensators kann auch die Wechselspannungsamplitude des invertierten Taktsignals am Kompensationskondensator über eine Widerstandsreihe bzw. einen Spannungsteiler eingestellt werden. Eine Variation des Spannungspegels wirkt sich durch Änderung des Stroms durch den Kompensationskondensator äquivalent zu einer Änderung des Kondensatorwertes aus. Da sich das Zuschalten von sehr kleinen Kapazitätswerten in der Größenordnung von Femto-Farad als schwer kontrollierbar erweisen kann, ist eine Kombination beider Verfahren vorteilhaft. Dabei wird die Grobeinstellung durch geschaltete Kondensatoren erreicht und die Feineinstellung durch geringfügige Variation des Spannungspegels.

Vorteilhafterweise erfolgt die Anpassung des Kompensationskondensator schrittweise, um der Dynamik des Systems Rechnung zu tragen. Je nach Art der verwendeten Kondensatorbank und/oder Widerstandsreihe können unterschiedliche Annäherungsstrategien angewandt werden. Bei einer Kondensator- oder Widerstandsbank mit einer Reihe von gleichen Kapazitäts- bzw. Widerstandswerten bietet sich eine lineare Annäherung an. Ein binärer Suchalgorithmus lässt sich einfacher mit einer Kondensatorbank realisieren, deren Kapazitätswerte binär verteilt sind, deren aufeinanderfolgende Kapazitätswerte also ein Verhältnis von 2:1 realisieren.

Sinnvollerweise wird der Kompensationskondensator beim Einschalten des Mikrofonbauelements initialisiert (sogenannter "Reset-to-Power-up"). In diesem Fall erfolgt die automatische Anpassung des Kompensationskondensators also noch vor dem eigentlichen Mikrofonbetrieb während der Initialisierungsphase nach dem Einschalten der Versorgungsspannung des Mikrofons.

In einer besonders vorteilhaften Weiterbildung der Erfindung wird der Gleichspannungs-Offset des Ausgangssignals des Demodulators aber nicht nur während dieser Initialisierungsphase erfasst, sondern auch während des eigentlichen Mikrofonbetriebs, um die Funktionsfähigkeit des Mikrofons zu überwachen und um Überlastsituationen, insbesondere einen elektrostatischen Kollaps der Elektroden des Mikrofonkondensators, frühzeitig zu erkennen und geeignete Gegenmaßnahmen zu treffen.

Tritt im Falle einer Überlastsituation eine Berührung zwischen der beweglichen Membran und der feststehenden Gegenelektrode auf, so wird der Mikrofonkondensator sehr groß. In diesem Moment steigt der Gleichspannungs-Offset sehr schnell stark an. Die Membran bleibt aufgrund der elektrostatischen Verhältnisse in der Regel an der Gegenelektrode haften. Eine derartige Überlastsituation wird in einer vorteilhaften Ausführungsform der Erfindung anhand des Anstiegs bzw. der Höhe des Gleichspannungs-Offset-Signals detektiert. Dazu wird der Gleichspannungs-Offset regelmäßig mit einem vorgegebenen maximalen Grenzwert bzw. "Fensterbereich" verglichen. Übersteigt der Gleichspannungs-Offset diesen maximalen Grenzwert bzw. "Fensterbereich", so wird z.B. nach einer gewissen Wartezeit oder Messzeit automatisch ein elektrischer Reset vorgenommen, bei dem der Mikrofonkondensator entladen wird, um die Membran von der Gegenelektrode zu lösen und die Mikrofonfunktion wieder herzustellen. Bei dieser Variante der Erfindung wird also rein schaltungstechnisch eine Art Überlastschutz für das Mikrofonbauelement realisiert. Auf entsprechende mechanische Maßnahmen kann hier verzichtet werden, was das Herstellungsverfahren für das erfindungsgemäße Bauelement insgesamt deutlich vereinfacht.

Die Überwachung des Gleichspannungsanteils kann außerdem dazu genutzt werden, die Einstellung des Kompensationskondensators während des Mikrofonbetriebs nachzuregeln, beispielsweise um Langzeitdrift-Erscheinungen entgegenzuwirken. Dazu wird in einer vorteilhaften Weiterbildung der Erfindung auch während des Mikrofonbetriebs eine automatische Anpassung des Kompensationskondensators vorgenommen, und zwar immer dann, wenn der Gleichspannungs-Offset über eine längere Zeitspanne hinweg ein durch einen weiteren Grenzwert bzw. Fensterbereich vorgegebenes Toleranzband verlässt. Dieser zweite Grenzwert wird deutlich kleiner gewählt, als der maximale Grenzwert, der den elektrostatischen Kollaps kennzeichnet. Dies wird nachfolgend anhand eines Ausführungsbeispiels der Erfindung noch näher erläutert.

In einer besonders vorteilhaften Weiterbildung der Erfindung wird der Gleichspannungsanteil des demodulierten Signals nicht nur zur Anpassung des Kompensationskondensators und/oder zur Überwachung der Mikrofonfunktion genutzt, sondern auch zur Detektion von auf das Mikrofonbauelement wirkenden Beschleunigungen. Dabei wird ausgenutzt, dass grundsätzlich jede kapazitive Mikrostruktur auch gegenüber Beschleunigungen, wie z.B. der Erdbeschleunigung, empfindlich ist. Wirkt eine Beschleunigung senkrecht auf die Mikrofonmembran ein, so wird diese aufgrund ihrer Masse und flexiblen Aufhängung ausgelenkt, was zu einer entsprechenden Kapazitätsänderung führt. Dabei handelt es sich in der Regel um statische oder zumindest sehr niederfrequente Kapazitätsänderungen, die sich im Signalverlauf des Gleichspannungsanteils wiederspiegeln. Das erfindungsgemäße Konzept ermöglicht also bei entsprechender Auswertung des Signalverlaufs des Gleichspannungsanteils die Detektion von senkrecht zur Mikrofonmembran wirkenden Beschleunigungen, ohne dass dazu ein zusätzliches Sensorelement erforderlich ist. Mit diesem Konzept lässt sich demnach nicht nur ein sehr kostengünstiges Mikrofon mit vergleichsweise hoher Empfindlichkeit und Robustheit realisieren, es bietet außerdem noch die Möglichkeit, Bewegungen oder einfach nur Lageänderungen des Einbaugeräts ohne zusätzliche Sensorelemente zu detektieren. Das erfindungsgemäße Bauelement könnte beispielsweise im Rahmen eines Telefons oder PDAs eingesetzt werden, um zu erkennen, ob das Gerät bewegt wird oder ruhig auf dem Tisch liegt, und dann automatisch zwischen Vibrationsalarm und Klingeln umzuschalten. Im Fall einer Telefonanwendung könnten einzelne Bedienaktionen, wie z.B. eine Tastensperre an- bzw. ausschalten oder einen eingehenden Anruf annehmen bzw. abweisen, durch einfache Gesten initiiert werden, wie z.B. durch Rotation des Geräts um eine bestimmte Achse.

Wie bereits erwähnt, werden die Beschleunigungsinformationen aus dem sehr niederfrequenten Signalanteil des demodulierten Signals ermittelt. Dieser niederfrequente Signalanteil von z.B. < 100 Hz kann durch eine entsprechende weitere Tiefpassfilterung des Ausgangssignals des Demodulators gewonnen werden, er kann aber auch mit Hilfe eines einfachen weiteren Tiefpassfilters vom Mikrofonsignal abgetrennt werden, während ein optionaler Hochpass das Verhalten klassischer Mikrofone am Ausgang nachbildet. Ein solcher Hochpass ist optional, weil in typischen Eingangsschaltungen für Mikrofone ohnehin schon ein Hochpass zur kapazitiven Entkopplung enthalten ist. Die technische Realisierung eines geeigneten Tiefpassfilters kann an verschiedenen Stellen erfolgen. Er kann beispielsweise in den ASIC integriert sein, so dass sich die Beschleunigung über ein weiteres Pin abgreifen lässt. Eine andere Möglichkeit besteht darin, den Tiefpassfilter auf der Trägerleiterplatte in Form von diskreten Bauteilen zu realisieren. Des Weiteren kann der Tiefpassfilter auch in den Signalverarbeitungsschaltkreis integriert sein, z.B. in den Chipsatz eines Mobiltelefons. Im Falle eines digitalen Mikrofonsignals kann der Tiefpassfilter schließlich auch als reine Softwarelösung realisiert werden, was besonders attraktiv ist, da hier keinerlei zusätzliche Bauteile oder Schaltungsänderungen notwendig sind.

Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die den unabhängigen Patentansprüchen nachgeordneten Patentansprüche verwiesen und andererseits auf die nachfolgende Beschreibung eines Ausführungsbeispiels der Erfindung anhand der Figuren.

Fig. 1        zeigt ein schematisches Schaltbild eines Mikrofonbauelements gemäß der DE 10 2009 000950.7 A1,

Fig. 2        zeigt ein schematisches Schaltbild eines erfindungsgemäßen Mikrofonbauelements,

Fig. 3        zeigt den zeitlichen Verlauf des Gleichspannungs-Offset-Signals während der Initialisierung eines erfindungsgemäßen Bauelements und während des anschließenden Mikrofonbetriebs,

Fig. 4a, b   zeigen jeweils eine Realisierungsmöglichkeit für den Kompensationskondensator eines erfindungsgemäßen Bauelements und

Fig. 5        zeigt den zeitlichen Verlauf des Gleichspannungs-Offset-Signals für den Fall einer binären Anpassung des Kompensationskondensators.

Ausführungsformen der Erfindung

Ein Hauptbestandteil des in der DE 10 2009 000950.7 A1 beschriebenen Bauelements wie auch des erfindungsgemäßen Bauelements ist eine mikromechanische Mikrofonstruktur, die eine akustisch aktive Membran und ein feststehendes akustisch durchlässiges Gegenelement umfasst. Die Membran und das Gegenelement bilden die auslenkbare und die feststehende Elektrode eines Mikrofonkondensators. Bei Schalleinwirkung ändert sich der Abstand zwischen der Membran und der Gegenelektrode und damit auch die Kapazität des Mikrofonkondensators.

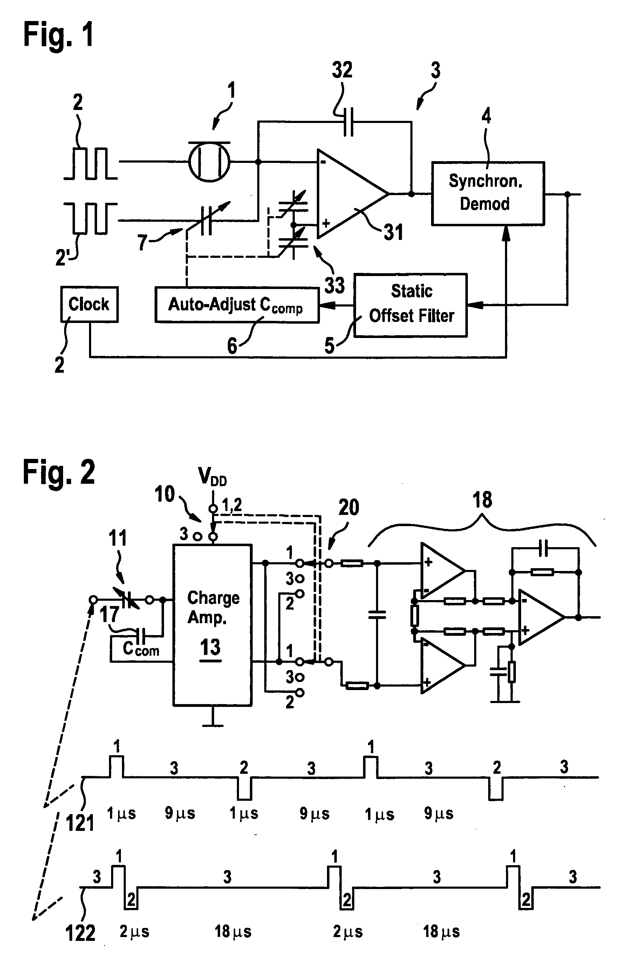

Bei dem in **Fig. 1** dargestellten und in der DE 10 2009 000950.7 A1 beschriebenen Bauelement wird der Mikrofonkondensator 1 zum Erfassen dieser Kapazitätsänderungen mit einem Abtastsignal in Form eines hochfrequenten Taktsignals 2 beaufschlagt. Der resultierende Stromfluss durch den Mikrofonkondensator 1 wird einem Eingang eines Ladungsverstärkers 31 zugeführt.

Neben dem akustisch aktiven Mikrofonkondensator 1 umfasst dieses Bauelement noch einen akustisch nicht aktiven einstellbaren Kompensationskondensator 7. Mit diesem soll der Strom kompensiert werden, der während der Beaufschlagung mit dem hochfrequenten Taktsignal durch den Mikrofonkondensator 1 im Ruhezustand fließt. Dazu wird der einstellbare Kompensationskondensator 7 mit dem invertierten Taktsignal 2' gespeist. Der resultierende Stromfluss durch den Kompensationskondensator 7 wird ebenfalls dem erwähnten Eingang des Ladungsverstärkers 31 zugeführt.

Der Operationsverstärker 31 bildet zusammen mit dem Kondensator 32 einen integrierenden Ladungsverstärker 3, der die Summe der Stromflüsse durch die beiden Kondensatoren 1 und 7 aufintegriert.

Idealerweise wird der Kompensationskondensator 7 so eingestellt, dass dessen Kapazität der Ruhekapazität des Mikrofonkondensators 1 entspricht. In diesem Fall heben sich die beiden Stromflüsse im Ruhezustand des Mikrofonkondensators 1 weitestgehend auf, bis auf die Abweichungen, die auf die schallbedingten Kapazitätsschwankungen des Mikrofonkondensators 1 zurückzuführen sind. Nur diese werden dann mit Hilfe des integrierenden Operationsverstärkers 3 aufintegriert.

Um aus dem Ausgangssignal des integrierenden Operationsverstärkers 3 ein Mikrofonsignal zu gewinnen, das die schallbedingten Kapazitätsschwankungen des Mikrofonkondensators 1 wiedergibt, wird dieses Ausgangssignal einem Demodulator 4 zugeführt, der mit dem Taktsignal 2 synchronisiert ist. Aus dem demodulierten Signal kann dann durch geeignete Tiefpassfilterung ein analoges Mikrofonsignal gewonnen werden. Beispielsweise durch zusätzliche Anwendung einer Sigma-Delta-Umwandlung kann alternativ auch direkt ein digitales Mikrofonsignal gewonnen werden, das mit dem Systemtakt des Einbaugeräts (Handy, PDA, etc.) synchronisiert ist.

Der Kompensationskondensator 7 wird hier automatisch eingestellt, und zwar während der Initialisierungs- bzw. Abgleichsphase des Mikrofonbauelements nach dem Einschalten seiner Versorgungsspannung. Dazu wird das Ausgangssignal des Demodulators 4 einem Tiefpassfilter 5 zugeführt, dessen obere Grenzfrequenz deutlich unter der unteren Grenzfrequenz des Mikrofons liegen sollte. Mit Hilfe dieses Tiefpassfilters 5 wird der Gleichspannungsanteil des demodulierten Signals ermittelt und damit letztlich die statische Asymmetrie zwischen Mikrofonkondensator 1 und Kompensationskondensator 7. Der Kompensationskondensator 7 wird nun mit Hilfe einer Regelungsstufe 6 automatisch so verändert, dass der Gleichspannungsanteil minimiert wird. Das Einsetzen dieser Regelung kann zeitverzögert so erfolgen, dass erst nach einer gewissen Wartezeit, innerhalb der permanent eine unzulässige Abweichung vorliegt, der Regler initiiert wird.

An dieser Stelle sei angemerkt, dass das Gleichspannungs-Offset-Signal nicht unbedingt direkt aus dem Ausgangssignal des Demodulators 4 gewonnen werden muss sondern auch aus dem Ausgangssignal einer nachfolgenden oder vorangehenden Verarbeitungsstufe gewonnen werden kann, solange der Gleichspannungsanteil noch nicht herausgefiltert worden ist.

Bei dem in Fig. 1 dargestellten Mikrofonbauelement ist dem Referenzeingang des Ladungsverstärkers 31 eine Referenzkondensatoranordnung 33 vorgeschaltet, die ebenfalls mit Hilfe der Regelstufe 6, also auf der Grundlage des überwachten Gleichspannungs-Offset-Signals, geregelt wird, um eine möglichst gute Rausch- und Störsignalunterdrückung gegenüber der Versorgungsspannung zu erzielen.

Mit Hilfe des in **Fig. 2** dargestellten Schaltbildes eines erfindungsgemäßen Mikrofonbauelements werden nachfolgend insbesondere die Unterschiede zu dem in der DE 10 2009 000950.7 A1 beschriebenen Mikrofonkonzept erläutert.

Auch das in Fig. 2 dargestellte Mikrofonbauelement umfasst einen Mikrofonkondensator 11 und einen akustisch nicht aktiven einstellbaren Kompensationskondensator 17. Zum Erfassen der schallbedingten Kapazitätsänderungen des Mikrofonkondensators wird dieser mit einem hochfrequenten Abtastsignal 121 bzw. 122 beaufschlagt, während der Kompensationskondensator mit dem invertierten Abtastsignal gespeist wird. Der resultierende Stromfluss durch den Mikrofonkondensator 11 sowie der resultierende Stromfluss durch den Kompensationskondensator 17 werden dem entsprechenden Eingang eines integrierenden Operationsverstärkers 13 zugeführt, der die Summe der Stromflüsse durch die beiden Kondensatoren 11 und 17 im Sinne eines Ladungsverstärkers aufintegriert.

Wie im Fall des in Fig. 1 dargestellten Mikrofonbauelement wird der Kompensationskondensator 17 möglichst so eingestellt, dass dessen Kapazität der Ruhekapazität des Mikrofonkondensators 11 entspricht. In diesem Fall heben sich die beiden Stromflüsse im Ruhezustand weitestgehend auf, bis auf die Abweichungen, die auf die schallbedingten Kapazitätsschwankungen des Mikrofonkondensators 11 zurückzuführen sind. Nur diese werden dann mit Hilfe des integrierenden Operationsverstärkers 13 aufintegriert und resultieren in einem dynamischen Ausgangssignal.

Erfindungsgemäß wurde der zeitliche Ablauf des Abtastprozesses gegenüber dem in Verbindung mit Fig. 1 erläuterten Mikrofonkonzept modifiziert. Anstelle eines hochfrequenten symmetrischen Taktsignals 2, 2' in Form einer Rechteckspannung mit einem 1:1-Verhältnis der Taktzeiten wird ein Abtastsignal, bestehend aus einer Abfolge von Abtastimpulsen und Pausenzeiten an die Kondensatoren 11 und 17 angelegt. Das symmetrische Taktsignal wurde hier also durch Einschieben von definierten Pausenzeiten zwischen einzelnen Abtastimpulsen oder Abtastsequenzen modifiziert. In Fig. 2 sind lediglich beispielhaft zwei derartig modifizierte Abtastsignale 121 und 122 mit Abtastimpulsen I und II gegensätzlicher Polarität dargestellt. Im Fall des Abtastsignals 121 liegen zwischen diesen Abtastimpulsen I und II zeitliche Pausen III, während sich das Abtastsignal 122 darstellt als eine periodische Abfolge von Pausenzeiten III und Abtastsequenzen, die aus zwei unmittelbar aufeinander folgenden Abtastimpulsen I und II bestehen.

Während der Pausenzeiten III wird der Stromfluss durch den integrierenden Operationsverstärker 13 deutlich abgesenkt oder sogar abgeschaltet. Dazu ist ein erstes Schaltelement 10 vorgesehen, das den Operationsverstärker 13 im hier dargestellten Ausführungsbeispiel während der Pausenzeiten III von der Versorgungsspannung $V_{DD}$ abkoppelt und insofern mit dem Abtastsignal 121 bzw. 122 synchronisiert ist. Daneben können auch weitere nicht benötigte Schaltungskomponenten während der Pausenzeiten abgeschaltet werden. Dieses erste Schaltelement 10 ist außerdem mit einem zweiten Schaltelement 20 am Ausgang des integrierenden Operationsverstärker 13 synchronisiert. Mit Hilfe dieses zweiten Schaltelements 20 wird der Ausgang des integrierenden Operationsverstärkers 13 nur während der eigentlichen Abtastung, also zu den Abtastimpulsen I und II, jeweils synchron mit einem nachgeschalteten Tiefpassfilterschaltkreis 18 verbunden. Während der Pausenzeiten III bleibt diese Verbindung jeweils unterbrochen. Auf diese Weise wird das Ausgangssignal des integrierenden Operationsverstärkers 13 synchron mit den Abtastvorgängen demoduliert und eine sogenannte "sample-and-hold"-Charakteristik realisiert. Der Tiefpassfilterschaltkreis 18 hat erfindungsgemäß eine "sample-and-hold"-Charakteristik, so dass er während der Pausenzeiten III zwar vom Ausgang des integrierenden Operationsverstärkers 13 elektrisch getrennt ist, aber den aus dem vorangegangenen Abtastvorgang resultierenden Spannungszustand über die Pausenzeit III speichert. Im hier dargestellten Ausführungsbeispiel ist der "sample-and-hold"-Tiefpassfilter in Form eines sogenannten Instrumentationsverstärkers realisiert. Die vorliegende Erfindung umfasst aber auch alternative Ausführungsformen mit äquivalenter oder überlegener Funktionalität. So kann beispielsweise auch ein Tiefpassfilter höherer Ordnung mit einer oder mehreren Polstellen in Verbindung mit einer "sample-and-hold"-Funktion verwendet werden. Bei einem digitalen Ausgangskreis wird das digitale Tiefpassfilter dann einfach einen "Zählerstand" als Bit-Wort während der Pausen zwischenspeichern bzw. als "Bit-Stream" ausgeben.

Wie bereits erwähnt wird im Falle des Abtastsignals 121 jeweils zwischen die einzelnen Abtastimpulse I und II des aus der DE 10 2009 000950.7 A1 bekannten symmetrischen Taktsignals eine definierte Pausenzeit III eingeschoben. Die Sampling-Rate des Abtastvorgangs liegt hier in einem Bereich um die 100 kHz. Da der Abtastvorgang keine weiteren Frequenzen umfasst, sind Interferenzen oder Nebeneffekte, bedingt durch mehrere Frequenzen im Abtastprozess bzw. Aliasing-Phänomene höherer Ordnung ausgeschlossen.

Bei diesem einfachen Abtastkonzept reduziert sich allerdings, bedingt durch die Stromabsenkung im integrierenden Operationsverstärker 13 während der Pausenzeiten III, die Korrelation des 1/f-Rauschsignals zwischen den Abtastzeiten I und II. Im Falle einer Stromabschaltung geht diese Korrelation sogar vollständig verloren. Deshalb kann bei Anwendung des Abtastsignals 121 eine effiziente Unterdrückung des 1/f-Rauschanteils nicht im ursprünglichen Ausmaß gewährleistet werden, der im hier relevanten Frequenzbereich um 100 kHz deutlich ausgeprägt ist und gegenüber dem über alle Frequenzen gleichverteilten thermischen Rauschen dominiert. In dieser Variante des Abtastkonzepts wird man also bevorzugt den Operationsverstärker 13 auch während der Pausen mit einem minimalen Ruhestrom > 0 versorgen, um eine Rauschkorrelation aufrecht zu erhalten.

Das Abtastsignal 122 trägt dem Erfordernis einer effizienten Rauschunterdrückung dadurch Rechnung, dass die Pausenzeiten III nicht zwischen die einzelnen Abtastimpulse eingeschoben sind, sondern zwischen Abtastsequenzen, die aus zwei unmittelbar aufeinanderfolgenden Abtastimpulsen I und II entgegengesetzter Polarität bestehen. Zwischen den Abtastimpulsen I und II einer Abtastsequenz besteht eine maximale Korrelation des 1/f-Rauschens, die im Demodulator eine effiziente Rauschunterdrückung ermöglicht, unabhängig davon, ob die Rauschkorrelation zwischen den einzelnen Abtastsequenzen, also über die Pausenzeiten hinweg, erhalten bleibt oder nicht. Deshalb kann im Fall des Abtastsignals 122 der Stromfluss durch den integrierenden Operationsverstärker während der Pausenzeiten ohne Rücksicht auf den Erhalt von Rauschkorrelationen weitestgehend reduziert oder sogar ganz abgeschaltet werden.

Allerdings sind bei diesem Abtastkonzept zwei Frequenzen am Abtastvorgang beteiligt, nämlich die schnelle Wiederholfrequenz der Abtastimpulse I und II innerhalb der Abtastsequenzen, die in einem Bereich von 500 kHz oder höher liegt, und die langsame Wiederholrate der Abtastsequenzen, die hier im Bereich um 50 kHz liegt. Entsprechend dieser niedrigen Abtastfrequenz muss der Tiefpassfilter am Ausgang mit einer steilen Abfallcharakteristik oberhalb seiner Eckfrequenz ausgelegt werden, um ein Übersprechen der Abtastimpulse selbst bzw. der Abtastvorgänge auf den Ausgang zu unterdrücken. Zudem ist durch eine eingangsseitige Unterdrückung von Mikrofonsignalen oberhalb von 25 kHz, also der halben niedrigsten Abtastfrequenz sicherzustellen, dass keine Aliasing-Phänomene auftreten können. Bei einem digitalen Ausgang, bei dem alle internen Taktsignale synchron mit dem Systemtakt des Einbaugeräts ablaufen, ist die Forderung der Taktunterdrückung im Tiefpassfilter entschärft.

Im Fall des Abtastsignals 122 wird der effektive Stromverbrauch des integrierenden Operationsverstärkers 13 um bis zu einem Faktor r abgesenkt, wobei

$$r = \text{Impuls (I+II) / Periodendauer (I+II+III)}$$

die Abtastimpuls-zu-Periodenrelation darstellt. Die maximale Stromabsenkung wird erreicht, wenn der integrierende Operationsverstärker während der Pausenzeiten III abgeschaltet wird. Bei r = 0,1, wie im hier erläuterten Ausführungsbeispiel, entspricht dies einer 90%-igen Stromeinsparung gegenüber der in DE 10 2009 000950.7 A1 beschriebenen Betriebsvariante.

Allerdings nimmt das Rauschen hinter dem Demodulator infolge der erfindungsgemäßen Abtastung um den Faktor 1/sqrt(r) zu. Um dies zu kompensieren und dasselbe Signal-Rausch-Verhältnis wie zuvor zu erhalten, wie bei der in DE 10 2009 000950.7 A1 beschriebenen Betriebsvariante, kann entweder einfach die Abtastspannung um den Faktor 1/sqrt(r) erhöht werden oder der Abstand zwischen Mikrofonmembran und Backplate entsprechend reduziert werden oder eine Kombination aus beiden Maßnahmen vorgenommen werden, so dass die Empfindlichkeit S des erfindungsgemäßen Mikrofonbauelements um eben diesen Faktor 1/sqrt(r) gesteigert wird. Die durch diese Maßnahmen bedingten Auswirkungen auf die Membran der Mikrofonstruktur heben sich gegenseitig auf, da die effektive Kraft auf die Membran mit dem Quadrat der angelegten Spannung, also ~ 1/r, und der Zeitdauer, über die diese Spannung anliegt, also - r, skaliert. Demnach bleibt auch das Risiko für einen elektrostatischen Kollaps der Mikrofonstruktur unverändert.

Die voranstehende Gegenüberstellung des in der DE 10 2009 000950.7 A1 beschriebenen Abtastkonzepts und des erfindungsgemäß modifizierten Abtastkonzepts veranschaulicht, dass der Stromverbrauch eines hier in Rede stehenden Mikrofonbauelements durch die erfindungsgemäßen Maßnahmen signifikant reduziert werden kann ohne negative Auswirkungen auf Performance und Mikrofonverhalten.

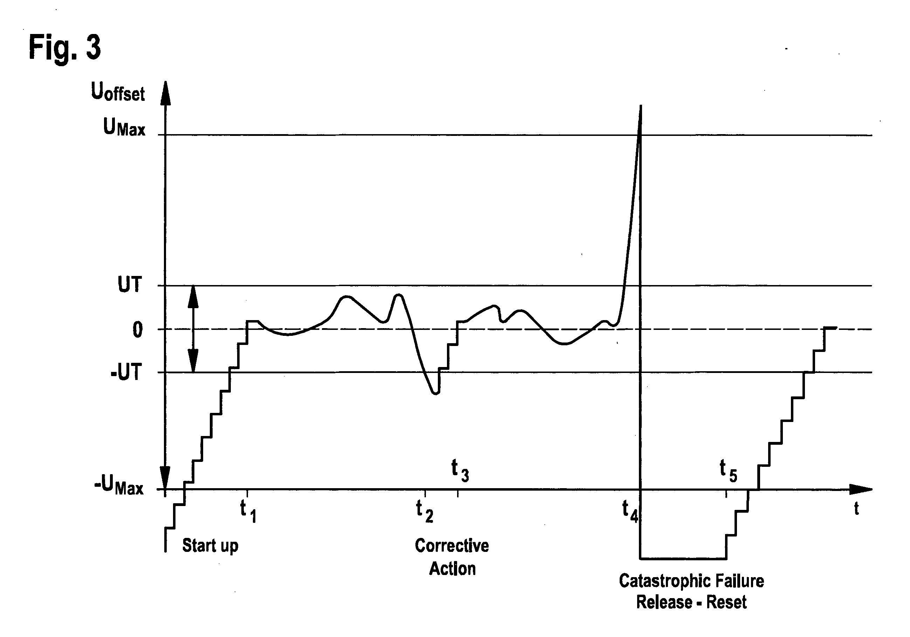

Die Anpassung und Regelung des Kompensationskondensators sowie die Überwachung der Mikroforifunktion eines erfindungsgemäßen Bauelements wird nachfolgend in Verbindung mit dem in **Fig. 3** dargestellten zeitlichen Verlauf des Gleichspannungs-Offset-Signals UOffset erläutert.

Im hier beschriebenen Ausführungsbeispiel wird der Kompensationskondensator des erfindungsgemäßen Bauelements ein erstes Mal während der Initialisierung nach "Power-up" des Bauelements eingestellt. Dies erfolgt schrittweise, wobei die Ruhekapazität des Mikrofonkondensators linear angenähert wird. Dazu wird der Gleichspannungsanteil des Ausgangssignals des Demodulators kontinuierlich oder zumindest regelmäßig überwacht und durch entsprechende Veränderung der Kapazität des Kompensationskondensators sukzessive minimiert. Diese Vorgehensweise hat den stufigen Signalverlauf bis zum Zeitpunkt t1 zur Folge. Zum Zeitpunkt t1 ist die Initialisierungsphase des Mikrofonbauelements und auch die Ersteinstellung des Kompensationskondensators für diese Betriebsphase abgeschlossen.

Ab dem Zeitpunkt t1 wird der Gleichspannungsanteil zur Überwachung der Mikrofonfunktion des Bauelements genutzt. Solange sich der Gleichspannungsanteil innerhalb eines durch den Grenzwert UT vorgegebenen Toleranzbandes um die Nulllinie bewegt, wie im Zeitraum zwischen t1 und t2, erfüllt die Mikrofonfunktion die angestrebten Qualitätskriterien. Im hier beschriebenen Ausführungsbeispiel deckt das Toleranzband ca. 10% des Spannungsbereichs des demodulierten Signals ab. Selbstverständlich können die Lage und Breite dieses Toleranzbandes auch anders gewählt werden, wobei in erster Linie die Mikrofon- und Schaltungscharakteristiken zu berücksichtigen sind.

Zum Zeitpunkt t2 wandert das Gleichspannungs-Offset-Signal aus dem Toleranzband heraus, indem der Gleichspannungs-Offset den unteren Grenzwert - UT unterschreitet. Dies löst entweder instantan oder nach Ablauf einer Wartezeit, in der das Offset-Signal permanent außerhalb der Grenzen liegt, eine automatische Nachregelung des Kompensationskondensators aus. Die Kapazität des Kompensationskondensators wird jetzt so verändert, dass sich der Gleichspannungs-Offset wieder innerhalb des vorgegebenen Toleranzbandes bewegt. Diese zweite Anpassung erfolgt ebenfalls in gleichmäßigen Schritten, was sich in dem stufigen Signalverlauf zwischen t2 und t3 wiederspiegelt.

Zum Zeitpunkt t4 steigt der Gleichspannungs-Offset stark an und übersteigt dabei nicht nur den Grenzwert UT sondern auch einen vorgegebenen maximalen Grenzwert Umax. Im hier beschriebenen Ausführungsbeispiel definiert der maximale Grenzwert Umax einen Spannungsbereich um der Nulllinie, der ca. 30% des Spannungsbereichs des demodulierten Signals abdeckt. Auch der maximale Spannungsbereich kann je nach Art der Anwendung und Bauteilcharakteristik anders gewählt werden.

Dieser Signalverlauf wird, eventuell nach einer gewissen Wartezeit, als elektrostatischer Kollaps des Mikrofonkondensators interpretiert, bei dem die Membran und die Gegenelektrode in Berührungskontakt treten und elektrostatisch aneinander haften bleiben. In diesem Fall wird ggf. nach Ablauf einer Wartezeit, innerhalb der geprüft wird, ob der Zustand permanent anhält, ein elektrischer Reset initiiert, bei dem der Mikrofonkondensator entladen wird, um die Membran von der Gegenelektrode zu lösen. Dazu kann beispielsweise eine eigene Schalteranordnung vorgesehen sein. Erst nach einer gewissen weiteren Wartezeit, zum Zeitpunkt t5, wird die Mikrofonfunktion wiederaufgenommen. Dann erfolgt auch eine erneute Anpassung des Kompensationskondensators, um den Gleichspannungs-Offset wieder zu minimieren und innerhalb des vorgegebenen Toleranzbandes zu halten.

Der in Fig. 3 dargestellte Verlauf des Gleichspannungs-Offset-Signals zeigt also, dass der Kompensationskondensator während der Anlauf-Phase des Mikrofons einmalig so eingestellt wird, dass der Gleichspannungs-Offset minimiert wird. Während des Mikrofonbetriebs bewegt sich der Gleichspannungs-Offset dann innerhalb eines vorgegebenen Toleranzbandes, das den Normalbetrieb des Mikrofons kennzeichnet. Dies wird beispielsweise mit Hilfe von Komparatoren, sogenannten "Fenster-Komparatoren", die ein zulässiges Betriebsfenster überwachen, kontinuierlich oder auch nur regelmäßig hin und wieder weiter überwacht. Solange sich der Gleichspannungs-Offset innerhalb des vorgegebenen Toleranzbandes bewegt, werden keine korrigierenden Maßnahmen zur Beeinflussung der Mikrofonfunktion getroffen. Nur in seltenen Fällen, beispielsweise aufgrund von Langzeitdrifterscheinungen, bewegt sich der Gleichspannungs-Offset langsam aus dem Toleranzband heraus. Dann wird nach einer gewissen Zeit, innerhalb der die Abweichung permanent detektiert wird, der Kompensationskondensator automatisch nachgeregelt, um den Gleichspannungs-Offset wieder zu minimieren bzw. auf das vorgegebene Toleranzband zu begrenzen. In Überlastsituationen, die einen Ausfall der Mikrofonfunktion zur Folge haben, ändert sich der Gleichspannungs-Offset stark und überschreitet dabei einen vorgegebenen maximalen Grenzwert, der deutlich außerhalb des Toleranzbandes liegt. In solchen Fällen wird ebenfalls nach einer Wartezeit, während der die Grenze überschritten bleibt, ein Reset durchgeführt, bei dem der Mikrofonkondensator vollständig entladen wird. Der Mikrofonbetrieb wird dann erst nach einer bestimmten Wartezeit wieder aufgenommen, wenn sichergestellt ist, dass sich die Membran wieder von der Gegenelektrode des Mikrofonkondensators gelöst hat. Dann wird auch der Kompensationskondensator wie in der ersten Anlauf-Phase des Mikrofons eingestellt, um den Gleichspannungs-Offset zu minimieren.

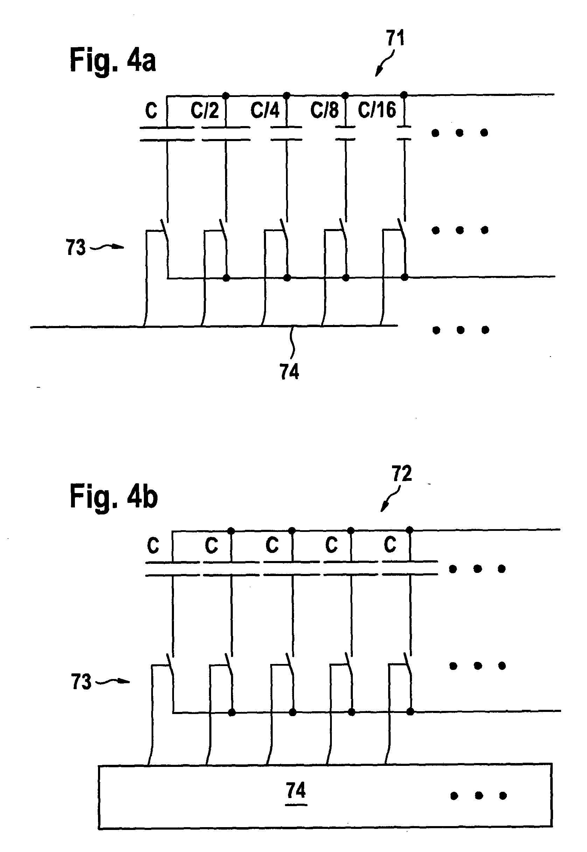

In den Figuren 4a und 4b sind zwei Realisierungsmöglichkeiten für einen einstellbaren Kompensationskondensator dargestellt. In beiden Fällen handelt es sich um eine schaltbare Kondensatorbank. Während die Kondensatorbank 71 der **Fig. 4a** eine binäre Verteilung von Kapazitätswerten, nämlich C, C/2, C/4, ..., umfasst, die über analoge Schalter 73 wahlweise zuschaltbar sind, besteht die Kondensatorbank 72 der **Fig. 4b** aus einer Reihe von gleichen Kapazitäten, die ebenfalls wahlweise zuschaltbar sind. In beiden Fällen werden die analogen Schalter über einen binären Decoder 74 angesteuert.

Wie bereits erwähnt, erfolgt die Anpassung des Kompensationskondensator meist schrittweise.

Im Fall eines linearen Näherungsverfahrens, wie es im Fall der Fig. 3 angewendet wurde, startet die Iteration bei einem vorgegebenen Kapazitätswert, der einem bestimmten digitalen Zählerstand des binären Decoders entspricht. Dabei kann es sich entweder um die größt mögliche oder auch um die kleinste realisierbare Kapazität der Kompensationskondensatoranordnung handeln. Es kann aber beispielsweise auch ein Kapazitätswert dazwischen gewählt werden, der auf einer Schätzung beruht. Je nach dem, ob sich der Gleichspannungs-Offset aufgrund der getätigten Einstellung des Kompensationskondensators vergrößert oder verkleinert hat, wird der Zählerstand des binären Decoders um Eins erhöht oder um Eins erniedrigt, was eine entsprechende Kapazitätserhöhung oderverringerung zur Folge hat. Diese Prozedur wird solange wiederholt, bis der Gleichspannungs-Offset minimal ist oder sich zumindest innerhalb des vorgegebenen Toleranzbandes bewegt. In diesem Fall werden bis zu 128 Iterationsschritte für einen 7-bit Decoder benötigt.

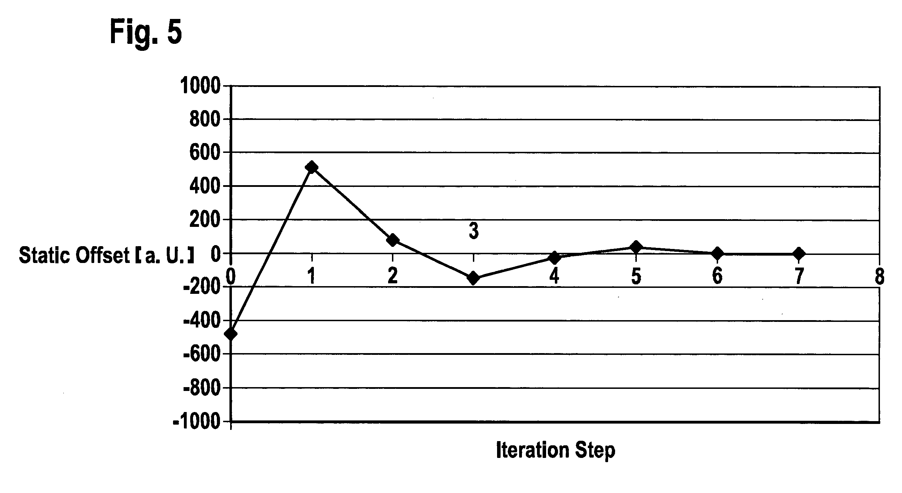

Fig. 5 veranschaulicht ein binäres Näherungsverfahren zur Anpassung des Kompensationskondensators. In diesem Fall erfolgt die Iteration anhand des Decoder Kontroll-Worts bit-weise. Im hier beschriebenen Ausführungsbeispiel werden zu Beginn der Iteration alle bit des Kontroll-Worts auf Null gesetzt, was der kleinsten mit der Kompensationskondensatoranordnung realisierbaren Kapazität entspricht. Diese Kapazität wird nun durch Setzen des ersten bits erhöht. Danach wird der Gleichspannungs-Offset mit der Nulllinie verglichen, um zu entscheiden, ob die zugeschaltete Kapazität zu groß oder nicht groß genug war, um eine optimale Anpassung zu erzielen. Falls die Kapazität zu groß war, wird sie wieder abgeschaltet und das entsprechende bit wird wieder auf Null gesetzt. Andernfalls wird die zugeschaltete Kapazität beibehalten. Ebenso wird mit den nachfolgenden bit des Decoder Kontroll-Worts verfahren. Fig. 5 zeigt den Verlauf des Gleichspannungs-Offsets für die ersten sieben bit des Decoder Kontroll-Worts, was 7 Iterationsschritten entspricht. Der hier beschriebene Algorithmus ist sehr stabil gegen Asymmetrien, die typischerweise bei Kapazitäten in integrierten Schaltkreisen auftreten. Zudem benötigt eine binäre Approximation im Vergleich zu einer linearen Approximation eine deutlich geringere Anzahl an Iterationsschritten, während aber ein größerer Kapazitätsbereich abgedeckt wird.

**Patentansprüche**

1. Mikrofonbauelement

    - mit einem mikromechanisch realisierten Mikrofonkondensator (11),
    - mit einem akustisch nicht aktiven Kompensationskondensator (17),
    - mit Mitteln zum Anlegen eines hochfrequenten Abtastsignals an den Mikrofonkondensator (11) und zum Anlegen des invertierten Abtastsignals an den Kompensationskondensator (17),
    - mit einem integrierenden Operationsverstärker (13), der die Summe des Stromflusses durch den Mikrofonkondensator (11) und des Stromflusses durch den Kompensationskondensator (17) aufintegriert,
- mit einem mit dem Abtastsignal synchronisierten Demodulator für das Ausgangssignal des integrierenden Operationsverstärkers (13) und
- mit einem Tiefpassfilter (18), um aus dem Ausgangssignal des Demodulators ein den Kapazitätsänderungen des Mikrofonkondensators (11) entsprechendes Mikrofonsignal zu gewinnen;

**dadurch gekennzeichnet,**

- **dass** das Abtastsignal (121; 122) aus einer periodischen Abfolge von Abtastimpulsen und Pausenzeiten besteht,
- **dass** mindestens ein erstes Schaltelement (10) vorgesehen ist, mit dem der Stromfluss durch den integrierenden Operationsverstärker (13) während der Pausenzeiten reduziert wird, und
- **dass** der Tiefpassfilter (18) eine "sample-and-hold"-Charakteristik aufweist, so dass der Tiefpassfilter (18) in den Pausenzeiten jeweils das Ausgangssignal des integrierenden Operationsverstärkers (13) gemittelt über den vorangegangenen Abtastvorgang speichert.

2. Mikrofonbauelement nach Anspruch 1, **dadurch gekennzeichnet, dass** weitere Schaltungselemente vorhanden sind, um weitere Schaltungskomponenten während der Pausenzeiten abzuschalten.

3. Mikrofonbauelement nach einem der Ansprüche 1 oder 2, **dadurch gekennzeichnet, dass** der Demodulator mindestens ein zweites Schaltelement (20) umfasst, mit dem die elektrische Verbindung zwischen dem integrierenden Operationsverstärker (13) und dem nachgeschalteten Tiefpassfilter (18) während der Pausenzeiten unterbrochen wird.

4. Mikrofonbauelement nach einem der Ansprüche 1 bis 3, **dadurch gekennzeichnet, dass** der Kompensationskondensator (17) einstellbar ist und dass Mittel zum automatischen Anpassen des Kompensationskondensators (17) an die Ruhekapazität des Mikrofonkondensators vorgesehen sind, umfassend

- einen Offset-Filter, mit dem der quasi-statische Anteil des Demodulator-Ausgangssignals ermittelt wird,
- Mittel zum Überwachen und Auswerten des quasi-statischen Anteils und zum Initiieren eines Regelvorgangs und
- eine Regelungskomponente zum Regeln des Kompensationskondensators, so dass der Gleichspannungsanteil des Demodulator-Ausgangssignals minimiert wird.

5. Mikrofonbauelement nach Anspruch 4, **dadurch gekennzeichnet, dass** die obere Grenzfrequenz des Offset-Filters deutlich kleiner ist als die untere Grenzfrequenz des Mikrofons.

6. Mikrofonbauelement nach einem der Ansprüche 4 oder 5, **dadurch gekennzeichnet, dass** die Mittel zum Überwachen und Auswerten des Gleichspannungsanteils mindestens einen Fensterkomparator umfassen, mit dem überwacht wird, ob sich der Gleichspannungsanteil zumindest weitgehend innerhalb vorgegebener Grenzen bewegt.

7. Mikrofonbauelement nach Anspruch 6, **dadurch gekennzeichnet, dass** die Regelungskomponente Mittel zum Initiieren eines elektrischen Resets umfasst.

8. Mikrofonbauelement nach einem der Ansprüche 4 bis 7, **dadurch gekennzeichnet, dass** der einstellbare Kompensationskondensator in Form einer schaltbaren Kondensatorbank ggf. in Kombination mit einer schaltbaren Widerstandsreihe realisiert ist.

9. Mikrofonbauelement nach einem der Ansprüche 4 bis 8, **dadurch gekennzeichnet, dass** dem Referenzeingang des integrierenden Operationsverstärkers mindestens ein regelbarer Referenzkondensator zur Rausch- und Störsignalunterdrückung vorgeschaltet ist, der zusammen mit dem Kompensationskondensator geregelt wird.

10. Mikrofonbauelement nach einem der Ansprüche 1 bis 9, **dadurch gekennzeichnet, dass** das Ausgangssignal in digitaler Form ausgegeben wird.

11. Verfahren zum Betreiben eines Mikrofonbauelements mit einem mikromechanisch realisierten Mikrofonkondensator (11) und mit einem akustisch nicht aktiven Kompensationskondensator (17),

- bei dem ein hochfrequentes Abtastsignal an den Mikrofonkondensator (11) angelegt wird und das invertierte Abtastsignal an den Kompensationskondensator (17) angelegt wird,

- bei dem die Summe des Stromflusses durch den Mikrofonkondensator (11) und des Stromflusses durch den Kompensationskondensator (17) mit Hilfe eines integrierenden Operationsverstärkers (13) aufintegriert wird, und

- bei dem das Ausgangssignal des integrierenden Operationsverstärkers (13) mit Hilfe eines mit dem Abtastsignal synchronisierten Demodulators demoduliert wird und durch eine Tiefpassfilterung des demodulierten Signals ein den Kapazitätsänderungen des Mikrofonkondensators (11) entsprechendes Mikrofonsignal gewonnen wird;

**dadurch gekennzeichnet,**

- **dass** das Abtastsignal (121; 122) aus einer periodischen Abfolge von Abtastimpulsen und Pausenzeiten besteht,

- **dass** der Stromfluss durch den integrierenden Operationsverstärker (13) während der Pausenzeiten reduziert wird,

- **dass** die elektrische Verbindung zwischen dem integrierenden Operationsverstärker (13) und dem nachgeschalteten Tiefpassfilter (18) während der Pausenzeiten unterbrochen wird, und

- **dass** der Tiefpassfilter (18) in den Pausenzeiten jeweils das Ausgangssignal des integrierenden Operationsverstärkers (13) gemittelt über den vorangegangenen Abtastvorgang speichert.

12. Verfahren nach Anspruch 11, **dadurch gekennzeichnet, dass** der integrierende Operationsverstärker (13) während der Pausenzeiten abgeschaltet wird.

13. Verfahren nach einem der Ansprüche 11 oder 12, **dadurch gekennzeichnet, dass** weitere Schaltungskomponenten während der Pausenzeiten abgeschaltet werden.

14. Verfahren nach einem der Ansprüche 11 bis 13, **dadurch gekennzeichnet, dass** das Abtastsignal (121) aus einer Abfolge von alternierend positiven und negativen Abtastimpulsen jeweils gefolgt von einer definierten Pausenzeit besteht.

15. Verfahren nach einem der Ansprüche 11 bis 14, **dadurch gekennzeichnet, dass** das Abtastsignal (122) aus einer Abfolge von zwei Abtastimpulsen gegensätzlicher Polarität gefolgt von einer definierten Pausenzeit besteht.

16. Verfahren nach einem der Ansprüche 11 bis 15, **dadurch gekennzeichnet, dass** die Abtastimpulsspannung so weit erhöht wird, dass der durch die Abtastung bedingte Anstieg des Rauschpegels N durch den Anstieg des Signalpegels S im Signal-Räuschabstand SNR = S/N zumindest teilweise kompensiert wird.

17. Verfahren nach einem der Ansprüche 11 bis 16, wobei der Kompensationskondensator einstellbar ist, **dadurch gekennzeichnet, dass** der Kompensationskondensator schrittweise, linear und/oder in einem binären Suchalgorithmus angepasst wird.

18. Verfahren nach Anspruch 17, **dadurch gekennzeichnet, dass** die automatische Anpassung des Kompensationskondensators an die Ruhekapazität des Mikrofonkondensators während der Initialisierung des Mikrofonbauelements erfolgt.

19. Verfahren nach einem der Ansprüche 11 bis 18, **dadurch gekennzeichnet, dass** der Gleichspannungsanteil des demodulierten Signals während des Mikrofonbetriebs regelmäßig, periodisch oder kontinuierlich überwacht wird.

20. Verfahren nach Anspruch 19, **dadurch gekennzeichnet, dass**, wenn der Gleichspannungsanteil einen vorgegebenen maximalen Grenzwert Umax über eine vorgegebene Zeitspanne übersteigt, ein elektrischer Reset initiiert wird, bei dem der Mikrofonkondensator vollständig entladen wird.

21. Verfahren nach einem der Ansprüche 17 bis 20, **dadurch gekennzeichnet, dass** eine automatische Anpassung des Kompensationskondensators vorgenommen wird, wenn der Gleichspannungsanteil ein durch einen weiteren Grenzwert (UT) vorgegebenes Toleranzband über eine vorgegebene Zeitspanne verlässt.

22. Verfahren nach einem der Ansprüche 16 bis 18, **dadurch gekennzeichnet, dass** durch Auswertung des Gleichspannungsanteils des demodulierten Signals Beschleunigungen detektiert werden, die senkrecht zur Membran des Mikrofonkondensators wirken.

23. Verfahren nach einem der Ansprüche 11 bis 22, **dadurch gekennzeichnet, dass** das Ausgangssignal des Mikrofonbauelements als digitales Signal, insbesondere als Bit-Stream (Sigma-Delta) oder PWM (Pulsweiten moduliertes Signal) ausgegeben wird synchron zum Systemtakt des Einbaugeräts.

**Claims**

1. Microphone component

   - having a micromechanically implemented microphone capacitor (11),
   - having an acoustically nonactive compensating capacitor (17),
   - having means for applying a high-frequency sampling signal to the microphone capacitor (11) and for applying the inverted sampling signal to the compensating capacitor (17),
   - having an integrating operational amplifier (13) which integrates the sum of the flow of current through the microphone capacitor (11) and the flow of current through the compensating capacitor (17),
   - having a demodulator, synchronized to the sampling signal, for the output signal from the integrating operational amplifier (13), and
   - having a low-pass filter (18) in order to obtain a microphone signal that corresponds to the changes of capacitance in the microphone capacitor (11) from the output signal to the demodulator;
   **characterized**
   - **in that** the sampling signal (121; 122) comprises a periodic series of sampling pulses and pause times,
   - **in that** at least one first switching element (10) is provided which is used to reduce the flow of current for the integrating operational amplifier (13) during the pause times, and
   - **in that** the low-pass filter (18) has a "sample-and-hold" characteristic, with the result that the low-pass filter (18) stores, in each of the pause times, the output signal from the integrating operational amplifier (13) averaged over the preceding sampling operation.

2. Microphone component according to Claim 1, **characterized in that** further circuit elements are present in order to disconnect further circuit components during the pause times.

3. Microphone component according to either of Claims 1 and 2, **characterized in that** the demodulator comprises at least one second switching element (20) which is used to interrupt the electrical connection between the integrating operational amplifier (13) and the downstream low-pass filter (18) during the pause times.

4. Microphone component according to one of Claims 1 to 3, **characterized in that** the compensating capacitor (17) is adjustable and **in that** means for automatically matching the compensating capacitor (17) to the quiescent capacitance of the microphone capacitor are provided, comprising

   - an offset filter which is used to ascertain the quasi-static portion of the demodulator output signal,
   - means for monitoring and evaluating the quasi-static portion and for initiating a regulatory operation, and
   - a regulatory component for regulating the compensating capacitor with the result that the DC voltage portion of the demodulator output signal is minimized.

5. Microphone component according to Claim 4, **characterized in that** the upper cut-off frequency of the offset filter is distinctly lower than the lower cut-off frequency of the microphone.

6. Microphone component according to either of Claims 4 and 5, **characterized in that** the means for monitoring and evaluating the DC voltage portion comprise at least one window comparator which is used to monitor whether the DC voltage portion varies at least largely within prescribed limits.

7. Microphone component according to Claim 6, **characterized in that** the regulatory component comprises means for initiating an electrical reset.

8. Microphone component according to one of Claims 4 to 7, **characterized in that** the adjustable compensating capacitor is implemented in the form of a switchable capacitor bank possibly in combination with a switchable resistor series.

9. Microphone component according to one of Claims 4 to 8, **characterized in that** the reference input of the integrating operational amplifier has at least one regulatable reference capacitor for noise and interference signal rejection connected upstream of it which is regulated together with the compensating capacitor.

10. Microphone component according to one of Claims 1 to 9, **characterized in that** the output signal is output in digital form.

11. Method for operating a microphone component having a micromechanically implemented microphone capacitor (11) and having an acoustically nonactive compensating capacitor (17),

- in which a high-frequency sampling signal is applied to the microphone capacitor (11) and the inverted sampling signal is applied to the compensating capacitor (17),
- in which the sum of the flow of current through the microphone capacitor (11) and the flow of current through the compensating capacitor (17) is integrated using an integrating operational amplifier (13), and
- in which the output signal from the integrating operational amplifier (13) is demodulated using a demodulator that is synchronized to the sampling signal and a microphone signal that corresponds to the changes of capacitance in a microphone capacitor (11) is obtained by low-pass filtering the demodulated signal;
**characterized**
- **in that** the sampling signal (121; 122) comprises a periodic series of sampling pulses and pause times,
- **in that** the flow of current through the integrating operational amplifier (13) is reduced during the pause times,
- **in that** the electrical connection between the integrating operational amplifier (13) and the downstream low-pass filter (18) is interrupted during the pause times, and
- **in that** the low-pass filter (18) stores, in each of the pause times, the output signal from the integrating operational amplifier (13) averaged over the preceding sampling operation.

12. Method according to Claim 11, **characterized in that** the integrating operational amplifier (13) is disconnected during the pause times.

13. Method according to either of Claims 11 and 12, **characterized in that** further circuit components are disconnected during the pause times.

14. Method according to one of Claims 11 to 13, **characterized in that** the sampling signal (121) comprises a series of alternately positive and negative sampling pulses each followed by a defined pause time.

15. Method according to one of Claims 11 to 14, **characterized in that** the sampling signal (122) comprises a series of two sampling pulses of opposite polarity followed by a defined pause time.

16. Method according to one of Claims 11 to 15, **characterized in that** the sampling pulse voltage is increased to an extent such that the rise in the noise level N that is brought about by the sampling is at least partially compensated for by the rise in the signal level (S) at the signal-to-noise ratio SNR = S/N.

17. Method according to one of Claims 11 to 16, wherein the compensating capacitor is adjustable, **characterized in that** the compensating capacitor is matched in steps, linearly and/or in a binary search algorithm.

18. Method according to Claim 17, **characterized in that** the automatic matching of the compensating capacitor to the quiescent capacitance of the microphone capacitor takes place during the initialization of the microphone component.

19. Method according to one of Claims 11 to 18, **characterized in that** the DC voltage portion of the demodulated signal is monitored regularly, periodically or continuously during the microphone operation.

20. Method according to Claim 19, **characterized in that**, when the DC voltage portion exceeds a prescribed maximum limit value $U_{max}$ over a prescribed period of time, an electrical reset is initiated, in which the microphone capacitor is completely discharged.

21. Method according to one of Claims 17 to 20, **characterized in that** automatic matching of the compensating capacitor is performed when the DC voltage portion leaves a tolerance band, prescribed by a further limit value (UT), over a prescribed period of time.

22. Method according to one of Claims 16 to 18, **characterized in that** evaluation of the DC voltage portion of the demodulated signal detects accelerations which act perpendicular to the diaphragm of the microphone capacitor.

**23.** Method according to one of Claims 11 to 22, **characterized in that** the output signal from the microphone component is output as a digital signal, particularly as a bit stream (sigma-delta) or PWM (pulse-width-modulated signal) in sync with the system clock of the installation appliance.

**Revendications**

**1.** Composant microphone

- comprenant un condensateur de microphone (11) réalisé sous forme micromécanique,
- comprenant un condensateur de compensation (17) non actif acoustiquement,
- comprenant des moyens pour appliquer un signal d'échantillonnage à haute fréquence au condensateur de microphone (11) et pour appliquer le signal d'échantillonnage inversé au condensateur de compensation (17),
- comprenant un amplificateur opérationnel intégrateur (13) qui intègre la somme du flux de courant à travers le condensateur de microphone (11) et du flux de courant à travers le condensateur de compensation (17),
- comprenant un démodulateur synchronisé avec le signal d'échantillonnage pour le signal de sortie de l'amplificateur opérationnel intégrateur (13) et
- comprenant un filtre passe-bas (18) pour obtenir, à partir du signal de sortie du démodulateur, un signal de microphone correspondant aux variations de la capacité du condensateur de microphone (11) ;
**caractérisé en ce**
- **que** le signal d'échantillonnage (121 ; 122) se compose d'une séquence périodique d'impulsions d'échantillonnage et de temps de pause,
- **qu'**il est prévu au moins un premier élément de commutation (10) avec lequel le flux de courant à travers l'amplificateur opérationnel intégrateur (13) est réduit pendant les temps de pause, et
- **que** le filtre passe-bas (18) présente une caractéristique « échantillonneur-bloqueur », de sorte que le filtre passe-bas (18), pendant les temps de pause, accumule à chaque fois la moyenne du signal de sortie de l'amplificateur opérationnel intégrateur (13) calculée sur l'opération d'échantillonnage précédente.

**2.** Composant microphone selon la revendication 1, **caractérisé en ce qu'**il existe des éléments de commutation supplémentaires pour déconnecter des composants supplémentaires du circuit pendant les temps de pause.

**3.** Composant microphone selon l'une des revendications 1 ou 2, **caractérisé en ce que** le démodulateur comprend au moins un deuxième élément de commutation (20) avec lequel la liaison électrique entre l'amplificateur opérationnel intégrateur (13) et le filtre passe-bas (18) branché à la suite est interrompue pendant les temps de pause.

**4.** Composant microphone selon l'une des revendications 1 à 3, **caractérisé en ce que** le condensateur de compensation (17) est réglable et **en ce que** des moyens sont prévus pour adapter automatiquement le condensateur de compensation (17) à la capacité au repos du condensateur de microphone, comprenant

- un filtre à décalage avec lequel est déterminée la composante quasi-statique du signal de sortie du démodulateur,
- des moyens pour surveiller et interpréter la composante quasi-statique et pour initier une opération de régulation et
- un composant de régulation pour régler le condensateur de compensation, de sorte que la composante de tension continue du signal de sortie du démodulateur soit minimisée.

**5.** Composant microphone selon la revendication 4, **caractérisé en ce que** la fréquence limite supérieure du filtre à décalage est nettement inférieure à la fréquence limite inférieure du microphone.

**6.** Composant microphone selon l'une des revendications 4 ou 5, **caractérisé en ce que** les moyens pour surveiller et interpréter la composante de tension continue comprennent au moins un comparateur à fenêtre qui surveille si la composante de tension continue varie au moins pour l'essentiel à l'intérieur de limites prédéfinies.

**7.** Composant microphone selon la revendication 6, **caractérisé en ce que** le composant de régulation comprend des moyens pour initier une réinitialisation électrique.

**8.** Composant microphone selon l'une des revendications 4 à 7, **caractérisé en ce que** le condensateur de compensation réglable est réalisé sous la forme d'un groupe de condensateurs commutable, le cas échéant en combinaison avec une série de résistances commutable.

9. Composant microphone selon l'une des revendications 4 à 8, **caractérisé en ce qu'**avant l'entrée de référence de l'amplificateur opérationnel intégrateur est branché au moins un condensateur de référence réglable destiné à l'atténuation du bruit et des signaux parasites, lequel est régulé conjointement avec le condensateur de compensation.

10. Composant microphone selon l'une des revendications 1 à 9, **caractérisé en ce que** le signal de sortie est délivré sous forme numérique.

11. Procédé pour faire fonctionner un composant microphone comprenant un condensateur de microphone (11) réalisé sous forme micromécanique et comprenant un condensateur de compensation (17) non actif acoustiquement,

- selon lequel un signal d'échantillonnage à haute fréquence est appliqué au condensateur de microphone (11) et le signal d'échantillonnage inversé est appliqué au condensateur de compensation (17),
- selon lequel la somme du flux de courant à travers le condensateur de microphone (11) et du flux de courant à travers le condensateur de compensation (17) est intégrée à l'aide d'un amplificateur opérationnel intégrateur (13), et
- selon lequel le signal de sortie de l'amplificateur opérationnel intégrateur (13) est démodulé à l'aide d'un démodulateur synchronisé avec le signal d'échantillonnage et un signal de microphone correspondant aux variations de la capacité du condensateur de microphone (11) est obtenu par un filtrage passe-bas du signal démodulé ;
**caractérisé en ce**
- **que** le signal d'échantillonnage (121 ; 122) se compose d'une séquence périodique d'impulsions d'échantillonnage et de temps de pause,
- **que** le flux de courant à travers l'amplificateur opérationnel intégrateur (13) est réduit pendant les temps de pause,
- **que** la liaison électrique entre l'amplificateur opérationnel intégrateur (13) et le filtre passe-bas (18) branché à la suite est interrompue pendant les temps de pause, et
- **que** le filtre passe-bas (18), pendant les temps de pause, accumule à chaque fois la moyenne du signal de sortie de l'amplificateur opérationnel intégrateur (13) calculée sur l'opération d'échantillonnage précédente.

12. Procédé selon la revendication 11, **caractérisé en ce que** l'amplificateur opérationnel intégrateur (13) est déconnecté pendant les temps de pause.

13. Procédé selon l'une des revendications 11 ou 12, **caractérisé en ce que** des composants de commutation supplémentaires sont déconnectés pendant les temps de pause.

14. Procédé selon l'une des revendications 11 à 13, **caractérisé en ce que** le signal d'échantillonnage (121) se compose d'une séquence d'impulsions d'échantillonnage alternativement positives et négatives, respectivement suivies par un temps de pause défini.

15. Procédé selon l'une des revendications 11 à 14, **caractérisé en ce que** le signal d'échantillonnage (122) se compose d'une séquence de deux impulsions d'échantillonnage aux polarités inverses, suivies par un temps de pause défini.

16. Procédé selon l'une des revendications 11 à 15, **caractérisé en ce que** la tension d'impulsion d'échantillonnage est augmentée suffisamment pour que l'augmentation du niveau de bruit N liée à l'échantillonnage soit compensée au moins partiellement par l'augmentation du niveau du signal S dans le rapport signal/bruit SNR = S/N.

17. Procédé selon l'une des revendications 11 à 16, selon lequel le condensateur de compensation est réglable, **caractérisé en ce que** le condensateur de compensation est adapté pas à pas, de manière linéaire et/ou dans un algorithme de recherche binaire.

18. Procédé selon la revendication 17, **caractérisé en ce que** l'adaptation automatique du condensateur de compensation à la capacité au repos du condensateur de microphone est effectuée pendant l'initialisation du composant microphone.

19. Procédé selon l'une des revendications 11 à 18, **caractérisé en ce que** la composante de tension continue du signal démodulé est surveillée régulièrement, périodiquement ou continuellement pendant le fonctionnement du microphone.

20. Procédé selon la revendication 19, **caractérisé en ce que** lorsque la composante de tension continue dépasse une valeur limite maximale prédéfinie Umax au-delà d'un intervalle de temps prédéfini, une réinitialisation électrique est initiée, lors de laquelle le condensateur de microphone est complètement déchargé.

21. Procédé selon l'une des revendications 17 à 20, **caractérisé en ce qu'**une adaptation automatique du condensateur de compensation est effectuée lorsque la composante de tension continue quitte une bande de tolérance prédéfinie par une valeur limite supplémentaire (UT) au-delà d'un intervalle de temps prédéfini.

22. Procédé selon l'une des revendications 16 à 18, **caractérisé en ce que** des accélérations qui agissent perpendiculairement à la membrane du condensateur de microphone sont détectées en interprétant la composante de tension continue du signal démodulé.

23. Procédé selon l'une des revendications 11 à 22, **caractérisé en ce que** le signal de sortie du composant microphone est délivré sous la forme d'un signal numérique, notamment d'un train de bits (sigma-delta) ou d'un signal PWM (modulation d'impulsions en largeur), synchronisé avec l'horloge système de l'appareil d'installation.

# Fig. 1

# Fig. 2

# Fig. 3

EP 2 392 148 B1

## Fig. 4a

71

C | C/2 | C/4 | C/8 | C/16

• • •

73

74

## Fig. 4b

72

C | C | C | C | C

• • •

73

74 • • •

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006008097 A

- DE 102009000950 A1